# FASCICULE DE BREVET EUROPEEN

(11) **EP 4 423 469 B1**
(45) Date de publication et mention de la délivrance du brevet: **06.08.2025**
(21) Numéro de dépôt: 22813659.4
(22) Date de dépôt: 26.10.2022
(51) Int. Cl.: G01K 1/14, G01K 11/3206, G01K 11/32, G01K 7/04

(54) **MODULE DE PUISSANCE À COMPOSANTS SEMI-CONDUCTEURS INTÉGRANT UN CAPTEUR DE TEMPÉRATURE ET PROCÉDÉ DE FABRICATION ASSOCIÉ**
LEISTUNGSMODUL MIT HALBLEITERBAUELEMENTEN MIT EINEM TEMPERATURSENSOR UND ZUGEHÖRIGES HERSTELLUNGSVERFAHREN
POWER MODULE HAVING SEMICONDUCTOR COMPONENTS AND INCORPORATING A TEMPERATURE SENSOR, AND ASSOCIATED MANUFACTURING METHOD

(30) Priorité: 26.10.2021 FR 2111366
(43) Date de publication de la demande: 04.09.2024
(73) Titulaire: SAFRAN, 75015 Paris (FR)
(72) Inventeur: KHAZAKA, Rabih, 77550 MOISSY-CRAMAYEL (FR); FEDI, Baptiste Joël Christian, 77550 MOISSY-CRAMAYEL (FR); SALHI, Nassim, 77550 MOISSY-CRAMAYEL (FR); PHAN HUY, Minh Chau, 77550 MOISSY-CRAMAYEL (FR)
(74) Mandataire: Ernest Gutmann - Yves Plasseraud S.A.S.
(86) Numéro de dépôt international: PCT/FR2022/052038
(87) Numéro de publication internationale: WO 2023/073323

(56) Documents cités:
- CN-A- 109 443 589
- GB-A- 2 479 942
- US-A1- 2014 197 514

## Description

### Domaine technique de l'invention

L'invention concerne le domaine des modules de puissance électrique comprenant des composants à semi-conducteurs. De tels modules sont en particulier destinés au domaine aéronautique.

### Etat de la technique antérieure

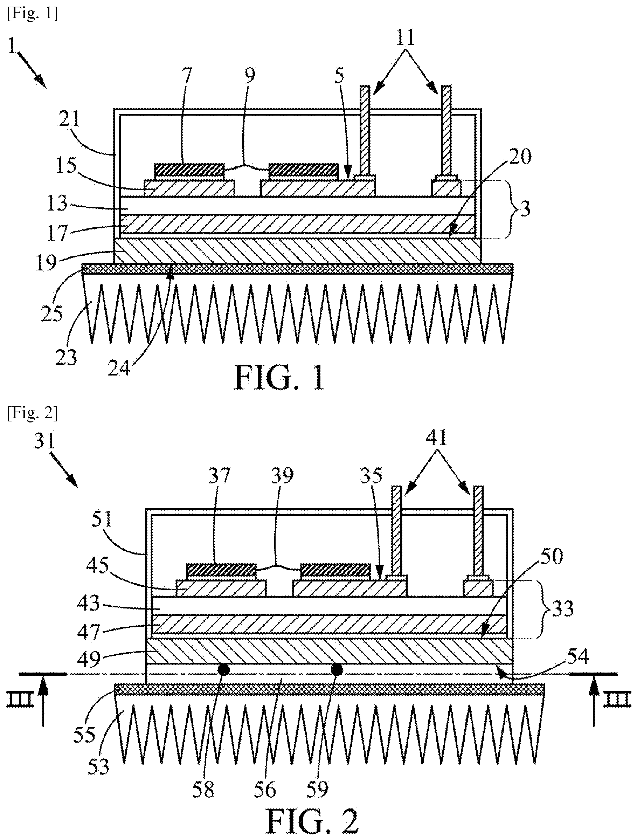

La figure 1 illustre un module de puissance 1 selon l'état de la technique. Le module de puissance 1 comprend un substrat 3 comprenant une face supérieure 5 recevant des composants 7 de puissance à semi-conducteurs.

Les composants 7 sont par exemple des interrupteurs de puissance (notamment des transistors à effet de champs à grille isolée, ou des transistors bipolaires à grille isolée), reliés entre eux par des fils de câblage 9 et reliés à des connecteurs 11 eux-mêmes connectés à une carte de commande (non représentée) configurée pour piloter lesdits composants 7.

Le substrat 3 est par exemple un substrat céramique, qui comprend une couche céramique 13 isolante séparant une métallisation supérieure 15, sur laquelle sont brasés les composants 5, d'une métallisation inférieure 17.

Une semelle 19 est brasée sur la métallisation inférieure 17 par une face supérieure 20 de ladite semelle 19, et un boitier 21 est fixé sur ladite semelle 19 métallique et vient recouvrir la métallisation supérieure 15 et les composants 5. Le boitier 21 est traversé par les connecteurs 11.

Afin d'avoir une dissipation thermique satisfaisante pour le module de puissance 1, un radiateur 23 est fixé à une face inférieure 24 de la semelle 19, à la face inférieure 9, par l'intermédiaire d'une couche de matériau d'interface thermique 25 recouvrant ladite face inférieure 9.

En effet, du fait de leurs imperfections, les composants 5 de puissance sont le siège de pertes thermiques par effet Joule et donc représentent une source importante de chaleur.

Lors du fonctionnement du module de puissance 1, les propriétés électriques des composants 3 peuvent varier de façons différentes (à cause d'un vieillissement prématuré de certains composants, de défauts de fabrication...), induisant une disparité importante. Cette disparité peut se traduire par des puissances dissipées qui peuvent être plus élevées dans certains composants induisant ainsi des augmentations de température locales.

De plus, au cours des cycles de vie du module, les sollicitations thermomécaniques peuvent amener à l'initiation et la propagation des fissures dans leur structure. Cette fissuration peut avoir lieu dans la brasure entre les composants 5 et le substrat 3, dans le substrat 3 ou dans la brasure entre le substrat 3 et la semelle 19. Elle provoque une augmentation de la résistance thermique du composant en dessous duquel la fissure se propage et, par conséquent, à une disparité de température entre les composants. Si ces déviations de températures locales ne sont pas détectées rapidement, elles peuvent amener à l'emballement thermique du module, entraînant sa défaillance totale.

Des solutions employant des capteurs de température ont été développées, afin de suivre les élévations de température dans le module de puissance au cours de son fonctionnement et ainsi prévenir une surchauffe.

L'intégration d'un tel capteur directement dans le composant à semi-conducteur limite les possibilités à une faible nombre de composants disponibles sur le marché et réduit grandement les possibilités d'adaptation des modules de puissance, qui doivent être réalisés sur mesure, ce qui induit des prix élevés.

La fixation du capteur sur le composant lui-même ou à proximité de celui-ci sur le substrat peut avoir un impact sur les performances électriques du composant, ne présente qu'une fiabilité limitée au cours des cycles thermiques du module, et ne présente pas une très bonne sensibilité à la fissuration ayant lieu sous le composant. Le document GB 2 479 942 A montre un module de puissance constitué d'une plaque en cuivre supportant des substrats en céramique.

### Présentation de l'invention

L'invention vise à remédier à ces inconvénients, en améliorant le contrôle de la température dans le module de puissance sans réduire de manière notable l'efficacité de la dissipation thermique ni perturber le fonctionnement du module.

A cet effet, l'invention a pour objet un module de puissance comprenant :
- une pluralité de composants de puissance à semi-conducteurs,
- un substrat comprenant une métallisation supérieure recevant les composants et une métallisation inférieure opposée à la métallisation supérieure,
- optionnellement, une semelle fixée à la métallisation inférieure du substrat,
- une structure métallique en contact direct avec une face inférieure définie par la semelle ou le substrat, d'un côté opposé aux composants,
- une structure métallique en contact direct avec la face inférieure, et
- au moins un capteur allongé de température, au moins partiellement noyé dans la structure métallique et s'étendant parallèlement à la face inférieure,
dans lequel la structure métallique est formée par électrodéposition sur la face inférieure et le capteur allongé.

Un tel module de puissance permet un suivi de température de chaque composant, permettant une détection améliorée et une localisation de problèmes thermiques dans le module de puissance. Le nombre de capteurs nécessaire pour suivre tous les composants est réduit, et les capteurs sont noyés dans la structure métallique, ce qui améliore la précision de la mesure de température et réduit fortement leur impact sur la dissipation thermique.

De plus, la structure métallique électroformée directement sur la face inférieure et le capteur constitue un lien continu entre ladite face inférieure de la semelle ou du substrat d'une part et la fibre optique d'autre part. Le contact thermique et mécanique est ainsi continu entre le substrat ou la semelle et la fibre optique, sans nécessiter d'interface de liaison intermétallique pouvant perturber les mesures de température. Cela permet aussi d'avoir une résistance thermique de contact bien maitrisée, contrairement au cas où la fibre est insérée dans un espace formé dans la semelle par exemple, permettant ainsi une mesure reproductible et fiable sur les différents composants.

De plus, contrairement à la brasure, le procédé d'électroformage est réalisé à basse température (par exemple de l'ordre de 60°C), ce qui limite les risques de dégradation de la fibre optique et de ses performances.

Le capteur allongé peut s'étendre au droit des composants, pour bénéficier d'une sensibilité améliorée.

La structure peut être réalisée préférentiellement en cuivre, et alternativement en nickel, argent, ou tout alliage de cuivre compatible avec une méthode d'électrodéposition.

La structure métallique peut être une plaque s'étendant sur au moins une partie de la face inférieure, la plaque présentant une épaisseur, mesurée perpendiculairement à ladite face inférieure, sensiblement constante sur son étendue.

Une telle structure présente une forme simple à fabriquer, permettant une intégration simplifiée et robuste du capteur allongé au module de puissance.

Un radiateur peut être fixé à la plaque, du côté opposé à la face inférieure, par exemple par l'intermédiaire d'une couche de matériau d'interface thermique.

La structure métallique peut être un radiateur thermique s'étendant sur au moins une partie de la face inférieure.

Une telle caractéristique permet de noyer directement le capteur allongé dans la structure du radiateur, qui peut être directement fabriqué sur la face inférieure par électrodéposition.

La présence du capteur allongé perturbe alors très peu le fonctionnement du radiateur, grâce à son intégration étroite au matériau.

Chaque capteur allongé peut comprendre une fibre optique, et en particulier est un capteur à fibre optique à réseau de Bragg ou un capteur à fibre optique à rétro-diffusion de Rayleigh.

Une telle caractéristique permet de suivre la température sur une pluralité de points avec un seul capteur allongé, le long de son étendue, avec une résolution spatiale de l'ordre du millimètre.

Chaque fibre optique peut présenter un diamètre externe inférieur à 100 micromètres et présente un profil adapté pour que la fibre optique puisse atteindre un rayon de courbure inférieur ou égal à 5 millimètres.

Une telle caractéristique permet de faire suivre un contour fortement courbé à la fibre optique sans générer de contraintes internes perturbant le signal, pour optimiser son cheminement sur la surface inférieure et mesurer la température d'autant de composants que possible par fibre. Chaque capteur allongé peut comprendre au moins un thermocouple.

Le module de puissance peut comprendre autant de thermocouples que de composants de puissance, chaque thermocouple étant avantageusement agencé au droit d'un des composants.

L'invention concerne également un procédé de fabrication d'un module de puissance comme plus haut, le procédé comprenant les étapes suivantes :
- fourniture d'un substrat présentant une métallisation supérieure destinée à recevoir des composants de puissance à semi-conducteurs et une métallisation inférieure opposée à la métallisation supérieure, et, optionnellement, d'une semelle fixée à la métallisation inférieure du substrat, la semelle ou le substrat présentant une face inférieure opposée aux composants,
- mise en place d'au moins un capteur allongé sur la face inférieure,
- formation de la structure métallique par électrodéposition sur la face inférieure et sur le capteur allongé.

La structure métallique peut être une plaque d'épaisseur sensiblement constante, le procédé comprenant en outre une étape de fixation d'un radiateur à la plaque, du côté opposé aux composants.

Le radiateur peut être fixé par l'intermédiaire d'une couche de matériau d'interface thermique. La structure métallique peut être un radiateur thermique dans lequel chaque capteur allongé est au moins en partie noyé, le procédé comprenant des étapes de :
- préparation, notamment par fabrication additive, d'une préforme adaptée pour mettre en forme le radiateur thermique,
- mise en place de la préforme sur la face inférieure et, optionnellement, d'un masque sur une partie de la face inférieure, et
- postérieurement à la formation de la structure métallique, retrait de la préforme et, le cas échéant, du masque.

Le retrait du masque et de la préforme peut être effectué par dissolution chimique ou thermique.

Le procédé est simple à mettre en œuvre contrairement au cas de la réalisation d'un canal pour venir encastrer la fibre sous les composants (dans le substrat ou la semelle), de largeur comprise entre 100µm et 500µm. En pratique, un tel canal présente souvent une forme assez complexe, notamment si les composants ne sont pas alignés, comme c'est souvent le cas, et nécessite des étapes techniques couteuses pour le réaliser (deux plaques à venir braser ensemble, techniques de fabrication additive très haute précision...).

Le module obtenu par le procédé selon l'invention est ainsi plus fiable en éliminant les brasures utilisés pour faire les joints d'attaches entre les différents éléments constituant, et ne nécessite pas de création d'interfaces intermétalliques fragiles, ne risquant pas de fissuration dans les brasures.

### Brève description des figures

[Fig. 1] la figure 1 est une vue en coupe schématique d'un module de puissance selon l'état de la technique,
[Fig. 2] la figure 2 est une vue en coupe schématique d'un module de puissance selon un premier mode de réalisation de l'invention,
[Fig. 3] la figure 3 est une vue en coupe schématique de dessous du module de puissance de la figure 1,
[Fig. 4] la figure 4 est une vue en coupe schématique de dessous d'un module de puissance selon un deuxième mode de réalisation de l'invention,
[Fig. 5] la figure 5 est une vue en coupe schématique d'un module de puissance selon un troisième mode de réalisation de l'invention, et
[Fig. 6] la figure 6 est une vue en coupe schématique de dessous du module de puissance de la figure 5.

### Description détaillée de l'invention

La figure 2 représente un module de puissance 31 selon l'invention. De manière identique à ce qui a été décrit plus haut, le module de puissance 31 comprend un substrat 33 définissant une face supérieure 35 sur laquelle sont brasés des composants électroniques 37 de puissance à semi-conducteurs reliés par des fils de câblage 39 et des connecteurs 41.

Le substrat 33 comprend une couche céramique 43 s'étendant entre une métallisation supérieure 45, sur laquelle sont brasés les composants 37 et les connecteurs 41, et une métallisation inférieure 47.

La métallisation inférieure 47 est brasée sur une semelle 49 métallique qui porte un boitier 51 venant recouvrir et protéger les composants 37.

La semelle 49 présente une face supérieure 50 sur laquelle est brasé le substrat et une face inférieure 54 qui s'étend du côté opposé au substrat 33.

Une structure métallique 56 s'étend en contact direct avec la face inférieure 54 de la semelle 49.

La structure métallique 56 est, dans le premier mode de réalisation, une plaque métallique sensiblement rectangulaire, en cuivre déposé sur la face inférieure 54 par électro-formation. Alternativement, la structure métallique 56 peut être réalisée en nickel, en argent, en alliage de cuivre, ou tout autre métal compatible avec l'électrodéposition.

Ladite plaque métallique présente une épaisseur sensiblement constante sur son étendue, mesurée perpendiculairement à la face inférieure 54, par exemple comprise entre 10 micromètres et 10 millimètres.

Le module de puissance 31 comprend au moins un capteur allongé 58 de température, au moins en partie noyé dans la structure métallique 56, et s'étendant le long de la face inférieure 54.

Le capteur allongé 58 comprend au moins une partie allongée qui s'étend selon une ligne courbe à travers la structure métallique 56.

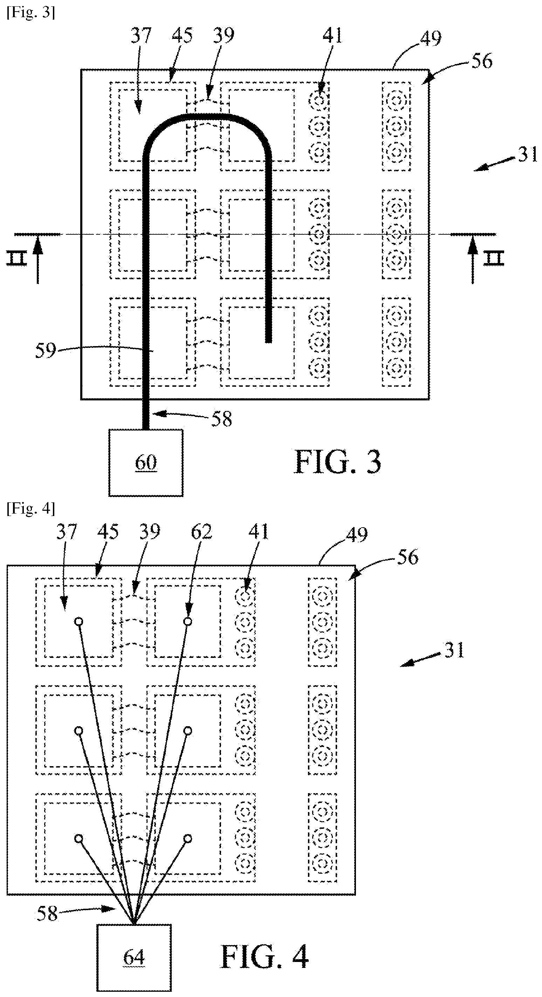

Dans le premier mode de réalisation, le capteur allongé 58 est un capteur de température à fibre optique, qui comprend une fibre optique 59, noyée dans la structure métallique 56 et un module de contrôle 60, représenté sur la figure 3, qui est à l'écart de ladite structure métallique 56.

Chaque fibre optique 59 est par exemple entourée d'un capillaire en cuivre qui est intégré lui-même dans la structure métallique 56 lors de sa formation par électrodéposition.

Le parcours de la fibre optique 59 le long de la face inférieure 54 de la semelle est représenté plus en détails sur la figure 3. La fibre optique 59 suit un parcours courbe passant avantageusement au droit de chacun des composants 37 de puissance à semi-conducteurs, afin d'en mesurer la température.

Le capteur allongé 58 est par exemple un capteur à un capteur de température à fibre optique à réseau de Bragg ou un capteur à fibre optique à rétro-diffusion de Rayleigh.

Selon une variante non représentée, le capteur 58 peut comprendre plusieurs fibres optiques s'étendant le long de la surface inférieure 54 selon des parcours différents les unes des autres. Chaque fibre optique 59 présente avantageusement un diamètre externe inférieur à 100 micromètres et présente un profil adapté pour que la fibre puisse atteindre un rayon de courbure inférieur ou égal à 5 millimètres. Cela permet à la fibre optique 59 de suivre un parcours tortueux suivant de près les composants 37.

On rappelle que le principe d'une fibre à réseau de Bragg consiste à modifier localement l'indice de réfraction du cœur de la fibre créant ainsi une série de réseaux (réseaux de Bragg). Chaque réseau réfléchit une longueur d'onde spécifique et différente des autres réseaux.

Chaque réseau permet de mesurer localement une température. Il est donc possible de mesurer une multitude de points de température sur une seule fibre optique.

On rappelle également qu'une fibre à rétro diffusion Rayleigh exploite les imperfections intrinsèquement présentes dans la fibre (dues aux hétérogénéités générées lors de la fabrication). Ces imperfections induisent des rétrodiffusions tout le long de la fibre (similaires à la présence de miroirs faiblement réfléchissant le long de la fibre). L'exploitation de ce signal de rétro diffusion permet de mesurer un phénomène physique (température ou déformation) et sa localisation.

Ces deux types de fibres sont à la fois sensibles à la température et à la déformation. L'intégration étroite de la fibre 59 dans la structure métallique 56 permet de bloquer les déformations de la fibre 59, assurant que le signal mesuré correspond uniquement à une variation de température.

Un procédé de fabrication du module de puissance 31 va maintenant être décrit. Le procédé comprend une étape préliminaire de fourniture et d'assemblage du substrat 33 et de la semelle 49, qui ne sera pas décrite plus avant car bien connue de l'état de la technique.

Le procédé comprend une étape de fixation d'une partie du capteur allongé 58, par exemple de la fibre optique 59, sur la face inférieure 54.

La fibre optique 59 est avantageusement logée dans un capillaire de protection, notamment dans un capillaire métallique, comme un capillaire en cuivre.

La fibre optique 59 est par exemple fixée par collage.

La fibre optique 59 suit un parcours sur la face inférieure 54 passant avantageusement au droit de chacun des composants 37.

Dans le cas où la fibre optique 59 est logée dans un capillaire non métallique, le procédé comprend une étape de dépôt d'une couche mince de métallisation sur ledit capillaire. La couche mince présente une épaisseur de quelques micromètres, et est formée suivant une méthode conventionnelle par pulvérisation cathodique, évaporation ou vaporisation, par exemple. Cette couche mince permet la formation de la structure métallique sur le capillaire à l'étape suivante.

Le procédé comprend ensuite une étape de formation de la structure métallique 56, ici une plaque métallique d'épaisseur sensiblement constante.

La structure métallique 56 est formée par électrodéposition dans un bain électrolytique, sur la face inférieure 54 et la fibre optique 59, afin de noyer ladite fibre optique dans ladite structure métallique 56. Cela permet d'avoir un excellent contact thermique entre la structure métallique 56 et la fibre optique 59, ainsi que d'assurer le maintien mécanique de la fibre optique 59.

Postérieurement à la formation de la plaque métallique 56, un radiateur 53 est fixé à ladite plaque métallique 56, du côté opposé à la semelle 49, par exemple par l'intermédiaire d'un matériau d'interface thermique 55.

Un module de puissance 31 selon un deuxième mode de réalisation de l'invention est représenté sur la figure 4. Ce module de puissance 31 est identique à celui précédemment décrit, à l'exception de ce qui suit.

Dans ce mode de réalisation, le capteur allongé 58 comprend une pluralité de thermocouples 62, notamment autant de thermocouples que de composants 37, reliés à un module de contrôle 64. Les thermocouples 62 sont situés avantageusement au droit de chacun des composants 37, au voisinage de la face inférieure 54 de la semelle 49, et noyés dans la couche métallique électrodéposée.

Le procédé de fabrication de ce module de puissance 31 est similaire au procédé précédent, avec des capteurs allongés de nature différente.

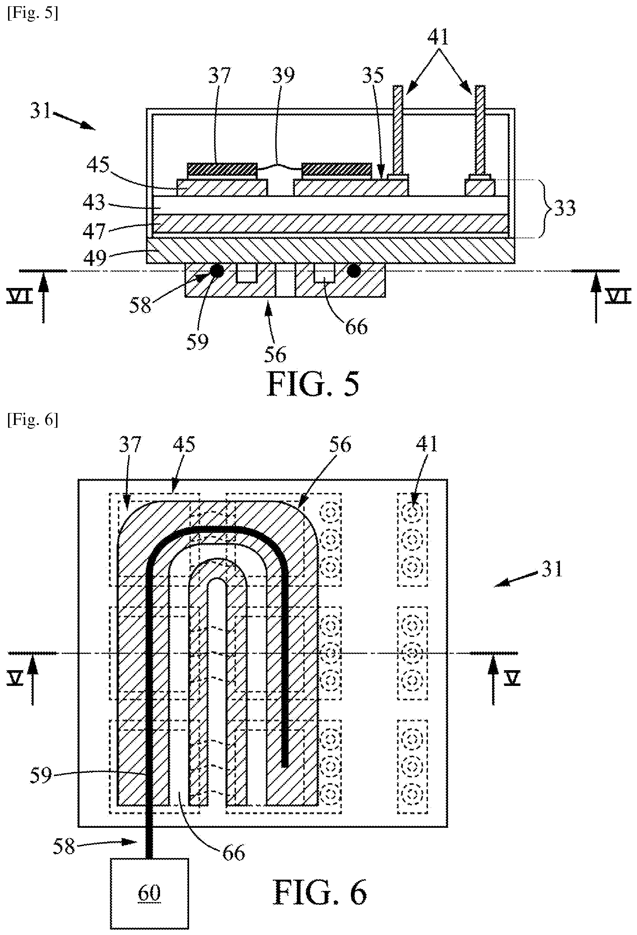

Un module de puissance 31 selon un troisième mode de réalisation de l'invention est représenté sur les figures 5 et 6.

Ce module de puissance 31 est identique au module selon le premier mode de réalisation de l'invention, à l'exception de ce qui suit.

Dans le troisième mode de réalisation, la structure métallique 56 est un radiateur thermique directement formé par électrodéposition sur la face inférieure 54 de la semelle 49, dans lequel est noyée la fibre optique 59 du capteur allongé 58.

Le radiateur métallique présente une forme allongée en U dans un plan parallèle à la face inférieure 54, comme représenté sur la figure 6, et s'étend au droit de chacun des composants 37.

Le radiateur présente une section extérieure sensiblement rectangulaire dans un plan transverse à son étendue, comme représenté sur la figure 5. La hauteur du radiateur, mesurée perpendiculairement à la face inférieure 54, est par exemple comprise entre 10 micromètres et 10 millimètres.

Le radiateur définit un canal central 66 conçu pour recevoir la circulation d'un fluide de refroidissement, et améliorer la dissipation thermique. Le canal interne 66 présente par exemple une section transverse carrée ou rectangulaire. Les dimensions de la section du canal interne 66 sont par exemple comprises entre 10 micromètres et 10 millimètres.

Le radiateur est par exemple réalisé en cuivre, ou alternativement en alliage de cuivre, ou tout autre métal compatible avec l'électrodéposition.

Le procédé de fabrication du module de puissance 31 selon le troisième mode de réalisation va maintenant être décrit, identique au procédé de fabrication du module de puissance selon le premier mode de réalisation à l'exception de ce qui suit.

Le procédé comprend une étape préliminaire de fabrication d'une préforme destinée à mettre en forme le radiateur.

La préforme est par exemple un élément allongé qui reproduit la forme du canal interne 66, de sorte que la préforme constitue un négatif de la forme finale du radiateur.

La préforme est par exemple réalisée par fabrication additive à partir d'un matériau polymère. La préforme est ensuite fixée à la face inférieure et recouverte d'une couche mince de métallisation. La couche mince présente une épaisseur de quelques micromètres, et est formée suivant une méthode conventionnelle par pulvérisation cathodique, évaporation ou vaporisation, par exemple. Cette couche mince permet la formation de la structure métallique sur la préforme par électrodéposition.

Un masque est ensuite appliqué sur une partie de la face inférieure 54 sur laquelle le radiateur n'est pas destiné à s'étendre. Le masque est par exemple un film polymère, sur lequel l'électrodéposition est impossible.

Le capteur allongé 58 est ensuite mis en place sur une région de la face inférieure sur laquelle va être formé le radiateur, et éventuellement métallisé si nécessaire, comme précédemment décrit.

Le radiateur est ensuite formé par électrodéposition dans un bain électrolytique sur la région non masquée de la face inférieure 54, sur la préforme et sur le capteur allongé 58, jusqu'au dépôt de l'épaisseur de métal désirée pour former le radiateur de la hauteur voulue.

La préforme et le masque sont ensuite retirés, soit mécaniquement lorsque cela est possible, soit par dissolution chimique et/ou thermique.

Selon une variante, les procédés selon les deux modes de réalisation décrits peuvent être mis en œuvre sur un module de puissance ne comprenant pas de semelle, le dépôt de la structure métallique 56 ayant lieu directement sur la métallisation inférieure 47 du substrat 33.

## Revendications

1. Module de puissance (31) comprenant :
- une pluralité de composants (37) de puissance à semi-conducteurs,
- un substrat (33) comprenant une métallisation supérieure (45) recevant les composants (37) et une métallisation inférieure (47) opposée à la métallisation supérieure (45),
- optionnellement, une semelle (49) fixée à la métallisation inférieure (47) du substrat (33),
- une structure métallique (56) en contact direct avec une face inférieure (54) définie par la semelle (49) ou le substrat (33), d'un côté opposé aux composants (37), et
- au moins un capteur allongé (58) de température, au moins partiellement noyé dans la structure métallique (56) ; le module de puissance (31) étant **caractérisé en ce que**
le capteur allongé de température (58) s'étend parallèlement à la face inférieure (54), et **en ce que**
la structure métallique (56) est formée par électrodéposition sur la face inférieure (54) et le capteur allongé (58).

2. Module de puissance (31) selon la revendication 1, dans lequel la structure métallique (56) est une plaque s'étendant sur au moins une partie de la face inférieure (54), la plaque présentant une épaisseur, mesurée perpendiculairement à ladite face inférieure (54), sensiblement constante sur son étendue.

3. Module de puissance (31) selon la revendication 1, dans lequel la structure métallique (56) est un radiateur thermique s'étendant sur au moins une partie de la face inférieure (54).

4. Module de puissance (31) selon l'une des revendications précédentes, dans lequel chaque capteur allongé (58) comprend une fibre optique (59), et en particulier est un capteur à fibre optique à réseau de Bragg ou un capteur à fibre optique à rétro-diffusion de Rayleigh.

5. Module de puissance (31) selon la revendication 4, dans lequel chaque fibre optique (59) présente un diamètre externe inférieur à 100 micromètres et présente un profil adapté pour que la fibre optique (59) puisse atteindre un rayon de courbure inférieur ou égal à 5 millimètres.

6. Module de puissance (31) selon l'une des revendications 1 à 3, dans lequel chaque capteur allongé (58) comprend au moins un thermocouple.

7. Procédé de fabrication d'un module de puissance (31) selon l'une des revendications précédentes, le procédé comprenant les étapes suivantes :
- fourniture d'un substrat (33) présentant une métallisation supérieure (45) destinée à recevoir des composants (37) de puissance à semi-conducteurs et une métallisation inférieure (47) opposée à la métallisation supérieure, et, optionellement, d'une semelle (49) fixée à la métallisation inférieure du substrat, la semelle (49) ou le substrat présentant une face inférieure opposée aux composants (37),
- mise en place d'au moins un capteur allongé (58) sur la face inférieure (54),
- formation de la structure métallique (56) par électrodéposition sur la face inférieure (54) et sur le capteur allongé (58).

8. Procédé selon la revendication précédente, dans lequel la structure métallique (56) est une plaque d'épaisseur sensiblement constante, le procédé comprenant en outre une étape de fixation d'un radiateur (53) à la plaque, du côté opposé à la face inférieure (54)

9. Procédé selon la revendication 7, dans lequel la structure métallique (56) est un radiateur thermique dans lequel chaque capteur allongé (58) est au moins en partie noyé, le procédé comprenant des étapes de :
- préparation, notamment par fabrication additive, d'une préforme adaptée pour mettre en forme le radiateur thermique,
- mise en place de la préforme sur la face inférieure (54) et, optionnellement, d'un masque sur une partie de la face inférieure (54), et
- postérieurement à la formation de la structure métallique (56), retrait de la préforme et, le cas échéant, du masque.

## Patentansprüche

1. Leistungsmodul (31), enthaltend:
- eine Vielzahl von Halbleiter-Leistungsbauteilen (37),
- ein Substrat (33) mit einer oberen Metallisierung (45), die die Bauteile (37) aufnimmt, und einer unteren Metallisierung (47), die der oberen Metallisierung (45) gegenüberliegt,
- optional eine Sohle (49), die an der unteren Metallisierung (47) des Substrats (33) befestigt ist,
- eine Metallstruktur (56) in direktem Kontakt mit einer Unterseite (54), die durch die Sohle (49) oder das Substrat (33) auf einer den Bauteilen (37) gegenüberliegenden Seite definiert ist, und
- zumindest einen länglichen Temperatursensor (58), der zumindest teilweise in die Metallstruktur (56) eingebettet ist;
wobei das Leistungsmodul (31) **dadurch gekennzeichnet ist, dass** sich der längliche Temperatursensor (58) parallel zur Unterseite (54) erstreckt, und dass die Metallstruktur (56) durch galvanische Abscheidung auf der Unterseite (54) und dem länglichen Sensor (58) gebildet ist.

2. Leistungsmodul (31) nach Anspruch 1,
wobei die Metallstruktur (56) eine Platte ist, die sich über zumindest einen Teil der Unterseite (54) erstreckt, wobei die Platte eine Dicke, gemessen senkrecht zu der Unterseite (54), aufweist, die über ihre Erstreckung im Wesentlichen konstant ist.

3. Leistungsmodul (31) nach Anspruch 1,
wobei die Metallstruktur (56) ein Wärmestrahler ist, der sich über zumindest einen Teil der Unterseite (54) erstreckt.

4. Leistungsmodul (31) nach einem der vorhergehenden Ansprüche,
wobei jeder längliche Sensor (58) eine optische Faser (59) umfasst und insbesondere ein faseroptischer Sensor mit Bragg-Gitter oder ein faseroptischer Sensor mit Rayleigh-Rückstreuung ist.

5. Leistungsmodul (31) nach Anspruch 4,
wobei jede optische Faser (59) einen Außendurchmesser von weniger als 100 Mikrometern aufweist und ein Profil hat, das so ausgelegt ist, dass die optische Faser (59) einen Krümmungsradius von 5 Millimetern oder weniger erreichen kann.

6. Leistungsmodul (31) nach einem der Ansprüche 1 bis 3,
wobei jeder längliche Sensor (58) zumindest ein Thermoelement umfasst.

7. Verfahren zur Herstellung eines Leistungsmoduls (31) nach einem der vorhergehenden Ansprüche, wobei das Verfahren die folgenden Schritte umfasst:
- Bereitstellen eines Substrats (33) mit einer oberen Metallisierung (45) zur Aufnahme von Halbleiter-Leistungsbauteilen (37) und einer unteren Metallisierung (47), die der oberen Metallisierung gegenüberliegt, und optional einer Sohle (49), die an der unteren Metallisierung des Substrats befestigt ist, wobei die Sohle (49) oder das Substrat eine den Bauteilen (37) gegenüberliegende Unterseite aufweist,
- Anbringen von zumindest einem länglichen Sensor (58) auf der Unterseite (54),
- Bilden der Metallstruktur (56) durch galvanische Abscheidung auf der Unterseite (54) und auf dem länglichen Sensor (58).

8. Verfahren nach dem vorhergehenden Anspruch,
wobei die Metallstruktur (56) eine Platte mit im Wesentlichen konstanter Dicke ist, wobei das Verfahren ferner einen Schritt des Befestigens eines Strahlers (53) an der Platte auf der der Unterseite (54) gegenüberliegenden Seite umfasst.

9. Verfahren nach Anspruch 7,
wobei die Metallstruktur (56) ein Wärmestrahler ist, in den jeder längliche Sensor (58) zumindest teilweise eingebettet ist, wobei das Verfahren die Schritte umfasst:
- Herstellen, insbesondere durch additive Fertigung, einer Vorform, die geeignet ist, den Wärmestrahler zu formen,
- Anbringen der Vorform auf der Unterseite (54) und optional einer Maske auf einem Teil der Unterseite (54), und
- nach dem Formen der Metallstruktur (56), Entfernen der Vorform und gegebenenfalls der Maske.

## Claims

1. Power module (31) comprising:
- a plurality of semiconductor-based power components (37);
- a substrate (33) comprising an upper metallization (45) receiving the components (37) and a lower metallization (47) opposite to the upper metallization (45);
- optionally, a baseplate (49) fixed to the lower metallization (47) of the substrate (33);
- a metal structure (56) in direct contact with a lower surface (54) defined by the baseplate (49) or the substrate (33), on the side opposite the components (37); and
- at least one elongated temperature sensor (58), at least partially immersed in the metal structure (56);
the power module (31) being **characterized in that** the elongated temperature sensor (58) extends parallel to the lower surface (54), and **in that** the metal structure (56) is formed by electrodeposition on the lower surface (54) and the elongated sensor (58).

2. Power module (31) according to claim 1, wherein the metal structure (56) is a plate spreading over at least one part of the lower surface (54), where the plate has a thickness, measured perpendicular to said lower surface (54), that is substantially constant over the extension thereof.

3. Power module (31) according to claim 1, wherein the metal structure (56) is a thermal radiator extending over at least a portion of the lower surface (54).

4. Power module (31) according to one of the preceding claims, wherein each elongated sensor (58) comprises an optical fiber (59), and in particular is a Bragg network optical fiber sensor or a Rayleigh backscattering optical fiber sensor.

5. Power module (31) according to claim 4, wherein each optical fiber (59) has an outer diameter less than 100 µm and has a suitable profile so that the optical fiber (59) has a radius of curvature less than or equal to 5 mm.

6. Power module (31) according to one of the claims 1 to 3, wherein each elongated sensor (58) comprises at least one thermocouple.

7. Fabrication method for a power module (31) according to one of the preceding claims, the method comprising the following steps:
- supplying a substrate (33) having an upper metallization (45) intended to receive semiconductor power components (37) and a lower metallization (47) opposite the upper metallization, and optionally a baseplate (49) attached to the lower metallization of the substrate, where the baseplate (49) or the substrate has a lower surface opposite the components (37);
- placement of at least one elongated sensor (58) on the lower surface (54);
- formation of the metal structure (56) by electrodeposition on the lower surface (54) and on the elongated sensor (58).

8. Method according to the previous claim, wherein the metal structure (56) is a plate of substantially constant thickness, the method further comprising a step of attachment of a radiator (53) to the plate, on the side opposite the lower surface (54).

9. Method according to claim 7 wherein the metal structure (56) is a thermal radiator in which each elongated sensor (58) is at least partially embedded, the method comprising the steps of:
- preparation, in particular by additive fabrication, of a preform suited for shaping the thermal radiator;
- placement of the preform on the lower surface (54) and, optionally, placement of a mask on a portion of the lower surface (54); and
- subsequent to the formation of the metal structure (56), withdrawal of the preform and, as applicable, the mask.
